(19) Europäisches Patentamt
European Patent Office
Office européen des brevets

(11) **EP 2 876 692 A1**

(12) **EUROPEAN PATENT APPLICATION**

(43) Date of publication:
**27.05.2015 Bulletin 2015/22**

(51) Int Cl.:
*H01L 31/046* (2014.01)          *H01L 31/0392* (2006.01)

(21) Application number: **14193933.0**

(22) Date of filing: **19.11.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **20.11.2013 KR 20130141611**

(71) Applicant: **Samsung SDI Co., Ltd.**
**Yongin-si, Gyeonggi-do (KR)**

(72) Inventor: **Kim, Dong-Jin**
**Gyeonggi-do (KR)**

(74) Representative: **Taor, Simon Edward William et al**
**Venner Shipley LLP**
**200 Aldersgate**
**London EC1A 4HD (GB)**

(54) **Solar cell and method for manufacturing the same**

(57)     A solar cell according to an example embodiment includes: a substrate; a plurality of first electrodes formed on the substrate and separated by a plurality of first separation grooves; a barrier layer formed in each of the first separation grooves; a photoactive layer formed on the first electrode and the barrier layer and including a through-groove that exposes a neighboring first electrode; and a second electrode formed on the photoactive layer and electrically connected with a neighboring first electrode through the through-groove.

FIG. 2

**Description**

The following description relates generally to a solar cell.

As a photovoltaic element that converts solar energy to electrical energy, a solar cell is gaining much interest as an unlimited and non-polluting next generation energy source.

A solar cell includes a p-type semiconductor and an n-type semiconductor, and when solar energy is absorbed at a photoactive layer, an electron-hole pair (EHP) is generated, the generated electrons and holes move to the n-type semiconductor and the p-type semiconductor respectively, and are collected by electrodes, to thereby be used (utilized) as electrical energy.

As the photoactive layer, a compound semiconductor including group I-III-VI elements may be used (utilized). The compound semiconductor may realize a high efficiency solar cell with a high light absorption coefficient and high optical stability.

When soda-lime glass is used (utilized) as a substrate of the solar cell including such a compound semiconductor, sodium (Na) included in the substrate may be diffused to the photoactive layer and the diffused sodium may affect efficiency of the solar cell.

However, the amount of diffused sodium (i.e., the atomic concentration of sodium atom in the photoactive layer) may vary depending on locations due to a layer structure between the substrate and the photoactive layer (to be discussed in more detail later). Here, the variation of the diffused sodium according to the locations may deteriorate efficiency of the solar cell.

The above information disclosed in this Background section is only for enhancement of understanding of the background of the described technology and therefore it may contain information that does not form the prior art that is already known in this country to a person of ordinary skill in the art.

An aspect according to one or more embodiments of the present invention is directed toward a solar cell including a copper indium gallium selenide (CIGS) semiconductor. The described technology has been made in an effort to provide a CIGS-based solar cell of which a photoactive layer has a uniform amount of sodium, and a method for manufacturing the same.

A solar cell according to an example embodiment includes: a substrate; a plurality of first electrodes on the substrate and separated by first separation grooves; a barrier layer in each of the first separation grooves; a photoactive layer on a corresponding first electrode of the first electrodes and the barrier layer, the photoactive layer including a through-groove exposing a neighboring first electrode of the first electrodes; and a second electrode on the photoactive layer and electrically connected with the neighboring first electrode through the through-groove. A thickness X of the barrier layer is calculated according to Equation 1.

Equation 1

$$Y = (-0.388)*\ln(X) + 2.25$$

where Y is a ratio of the amount of sodium in a region (or area) of the photoactive layer overlapping with the barrier layer with respect to the amount of sodium in a region of the photoactive layer overlapping with areas other than the barrier layer.

The barrier layer may include an insulating material, and the insulating material may include at least one of $SiO_x$, $SiN_x$, and $SiO_xN_y$. The thickness X of the barrier layer may be 20.3 nm to 30.3 nm.

The first electrode may include molybdenum, and the second electrode may include IZO, ITO, and/or AZO.

The photoactive layer may include a CIGS-based material.

The second electrode may include a second separation groove exposing the neighboring first electrode, and the through-groove may be between a corresponding one of the first separation grooves separating the corresponding first electrode from the neighboring first electrode and the second separation groove.

According to another example embodiment, a method of manufacturing a solar cell includes: forming a plurality of first electrodes including a plurality of first separation grooves on a substrate; forming a barrier layer including an insulating material in each of the first separation grooves; forming a photoactive layer on a corresponding first electrode of the first electrodes and the barrier layer, the photoactive layer including a through-groove configured to expose a neighboring first electrode of the first electrodes; and forming a second electrode electrically connected with the neighboring first electrode through the through-groove on the photoactive layer. A thickness X of the barrier layer may be calculated according to Equation 1.

Equation 1

$$Y = (-0.388)*\ln(X) + 2.25$$

where Y is a ratio of the amount of sodium in a region of the photoactive layer overlapping with the barrier layer with respect to the amount of sodium in a region of the photoactive layer overlapping with areas other than the barrier layer.

The forming the barrier layer may include: disposing a deposition mask configured to expose the first separation grooves on the first electrodes; depositing the insulating material to each of the first separation grooves using (utilizing) a chemical vapor deposition or sputtering method; and removing the deposition mask.

The barrier layer may include at least one of $SiN_x$, $SiO_x$, and $SiO_xN_y$.

According to an aspect of the invention, there is provided a solar cell as set out in claim 1. Preferred features are set out in claims 2 to 7.

According to an aspect of the invention, there is provided a method of manufacturing a solar as set out in claim 8. Preferred features are set out in claims 9 and 10.

According to the example embodiments, the solar cell is formed so that a content of sodium in a photoactive layer becomes uniform, thereby increasing efficiency of the solar cell.

FIG. 1 is a schematic top plan view of a solar cell according to an example embodiment.

FIG. 2 is a cross-sectional view of FIG. 1, taken along the line II-II.

FIG. 3 to FIG. 6 are cross-sectional views showing intermediate acts of a method for manufacturing a solar cell according to an example embodiment.

The present invention will be described more fully hereinafter with reference to the accompanying drawings, in which example embodiments of the invention are shown. As those skilled in the art would realize, the described embodiments may be modified in various different ways, all without departing from the scope of the present invention.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present. Expressions such as "at least one of," when preceding a list of elements, modify the entire list of elements and do not modify the individual elements of the list. Further, the use of "may" when describing embodiments of the present invention refers to "one or more embodiments of the present invention."

Hereinafter, a solar cell will be described in more detail with reference to the accompanying drawings.

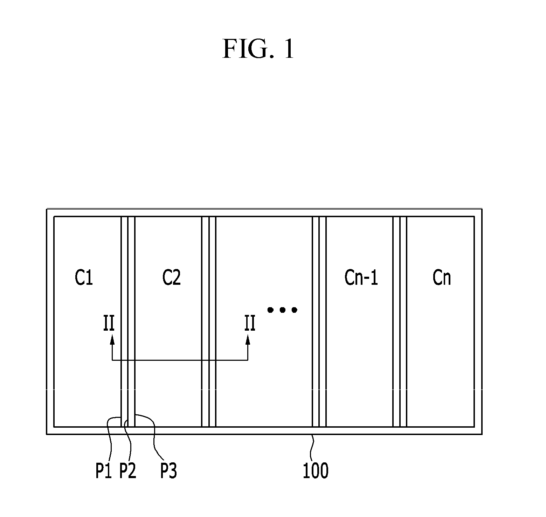

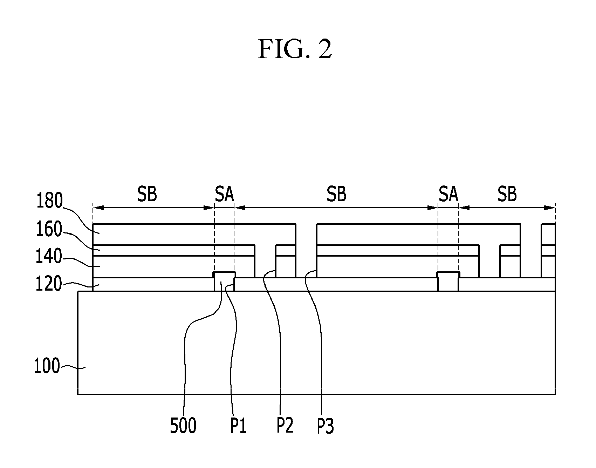

FIG. 1 is a schematic top plan view of a solar cell according to an example embodiment, and FIG. 2 is a cross-sectional view of FIG. 1, taken along the line II-II.

As shown in FIG. 1 and FIG. 2, a solar cell according to an example embodiment includes a plurality of cells $C_1$ to Cn formed on a substrate 100. Each cell includes a first electrode 120, a photoactive layer 140 formed on the first electrode 120, a buffer layer 160 formed on the photoactive layer 140, and a second electrode 180 formed on the buffer layer 160, and every neighboring cells (e.g., $C_1$ and $C_2$) are electrically connected with each other.

Referring to FIG. 2, a layer structure of the solar cell of FIG. 1 will be described in further detail.

As shown in FIG. 2, a plurality of first electrodes 120 are formed on the substrate 100. The first electrodes 120 are separated from each other by first separation grooves $P_1$ that are formed to have a constant gap (i.e., a gap with a constant width). Here, the width of the first separation groove $P_1$ may be $20\mu m$ to $100\mu m$.

The substrate 100 may be a transparent and insulating glass substrate such as soda-lime glass.

The first electrode 120 may be made of a metal having a suitable (e.g., an excellent) heat resistance characteristic, a suitable (e.g., an excellent) electric contact characteristic with respect to a material that forms the photoactive layer 140, a suitable (e.g., an excellent) electrical conductivity, and a suitable (e.g., an excellent) interface adherence with the substrate 100. For example, the first electrode 120 may be made of molybdenum (Mo).

A barrier layer 500 is formed in the first separation groove $P_1$. The barrier layer 500 may be made of an insulating material that insulates between every neighboring first electrodes 130 while filling in the first separation groove $P_1$, and for example, may include at least one of $SiO_x$, $SiN_x$, and $SiO_xN_y$.

A photoactive layer 140 and a buffer layer 160 are formed on each of the first electrodes 120.

The photoactive layer 140 is a p-type CIS-based semiconductor, and may include selenium (Se) and/or sulfur (S). For example, the photoactive layer 140 may include $Cu(In_{1-x},Ga_x)(Se_{1-x},S_x)$ as a group I-III-VI-based semiconductor compound, and may be a compound semiconductor having a composition of $0 \leq x \leq 1$. The photoactive layer 140 may have a single phase of which the composition in the compound semiconductor is substantially uniform throughout the photoactive layer. For example, the photoactive layer 140 may include CuInSe2, CuInS2, Cu(In,Ga)Se2, (Ag,Cu)(In,Ga)Se2, (Ag,Cu) (In,Ga) (Se,S)$_2$, Cu(In,Ga) (Se,S)$_2$, and/or Cu(In,Ga)S$_2$.

The photoactive layer 140 may further include sodium (Na), which is diffused from the substrate 100.

The buffer layer 160 is made of an n-type semiconductor material having high light transmittance, and reduces an energy gap difference between the photoactive layer 140 and the second electrode 180. The buffer layer 160 is made of an n-type semiconductor material having high light transmittance, and for example, may be made of cadmium sulfide (CdS), zinc sulfide (ZnS) and/or indium sulfide (InS).

The buffer layer 160 and the photoactive layer 140 include a through-groove P$_2$ that exposes the first electrodes 120. Here, the through-groove P$_2$ exposes the first electrodes 120 of neighboring cells (e.g., the buffer layer 160 and the photoactive layer 140 include a through-groove P$_2$ which exposes a first electrode 120 directly under the through-groove P$_2$). In one embodiment, the buffer layer 160 and the photoactive layer 140 include a plurality of through-grooves P$_2$, each exposing a corresponding one of the plurality of first electrodes 120 directly under that through-groove P$_2$. The through-groove P$_2$ may have a width of 20$\mu$m to 100$\mu$m.

A second electrode 180 is formed on the buffer layer 160.

The second electrode 180 may be made of a material having high light transmittance and suitable (e.g., excellent) electrical conductivity, and for example, may be formed in a single layer or a multilayer of indium tin oxide (ITO), indium zinc oxide (IZO), and/or zinc oxide (ZnO). The light transmittance may be over about 80%. Here, the ZnO layer may have a low resistance value by being doped with aluminum (Al) and/or boron (B).

When the second electrode 180 is formed in a multilayer, an ITO layer (having an excellent electro-optical characteristic) may be layered on a ZnO layer, or an n-type ZnO layer (having a low resistance value by being doped with a conductive impurity) may be layered on an i-type (intrinsic) ZnO layer (that is not doped with a conductive impurity).

The second electrode 180 is an n-type semiconductor, and forms a pn junction with the photoactive layer 140, which is a p-type semiconductor.

The second electrode 180 includes a second separation groove P$_3$ that exposes the first electrode 120. Here, the second separation groove P$_3$ exposes the first electrodes 120 of a neighboring cell (e.g., the second electrode 180 includes a second separation groove P$_3$ which exposes a first electrode 120 directly under the second separation groove P$_3$). In one embodiment, the second electrode 180 includes a plurality of second separation grooves P$_3$, each exposes one of the plurality of first electrodes 120 directly under that second separation groove P$_3$. The second separation groove P$_3$ may have a width of 20$\mu$m to 100$\mu$m.

According to the example embodiment, sodium content of the photoactive layer may be made uniform throughout the substrate by forming a barrier layer in the first separation groove.

When sodium is diffused to the photoactive layer 140, the amount of sodium passing through the first separation groove P$_1$ and the amount of sodium passing through the first electrode 120 become similar to each other due to the barrier layer 500, thereby maintaining the amount of sodium diffused throughout the substrate 100 to be uniform. Here, the thickness X of the barrier layer 500 may be acquired (determined) according to Equation 1.

Equation 1

$$Y= (-0.388)*\ln (X)+2.25$$

where Y is a ratio of the amount of sodium in an area SA of the photoactive layer that overlaps with the barrier layer with respect to the amount of sodium in an area SB of the photoactive layer overlapping with areas other than the barrier layer. Hereinafter, a method for manufacturing a solar cell according to an example embodiment will be described with reference to FIG. 2 and FIG. 3 to FIG. 6.

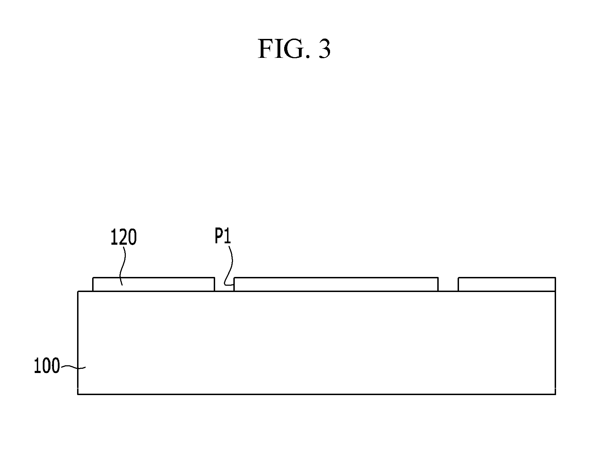

FIG. 3 to FIG. 6 are cross-sectional views of intermediate acts in manufacturing of a solar cell according to an example embodiment.

As shown in FIG. 3, a metal layer (such as one made of molybdenum) is formed on a substrate 100 using (utilizing) a sputtering method.

Then, a plurality of first electrodes 120 are formed by forming separation grooves P1 using (utilizing) a laser or a dicing saw.

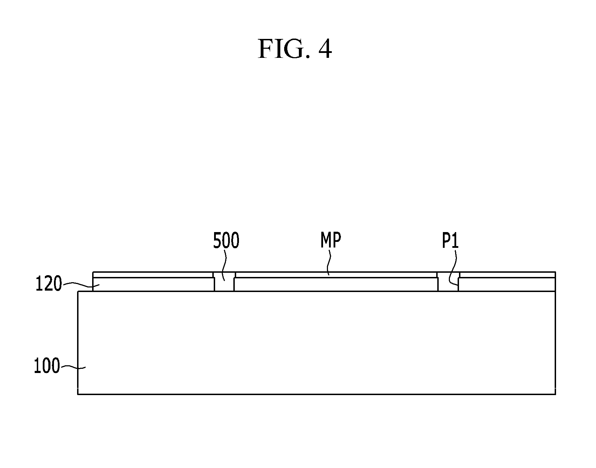

As shown in FIG. 4, barrier layers 500 are formed by filling in the first separation grooves P$_1$ with an insulating material.

A deposition mask MP that exposes the first separation grooves P1 is disposed on the first electrode 120 and then the insulation material is deposited to the first separation grooves P1 using (utilizing) a chemical vapor deposition (CVD) method or a sputtering method such that the barrier layer 500 is formed.

Here, the thickness of the barrier layer 500 may be determined according to Equation 1 as previously described.

For example, referring to FIG. 2, when the amount of sodium is uniform through the entire area of the photoactive layer, the amount of sodium of an area SA and the amount of sodium of an area SB are equivalent to each other. Therefore, the ratio Y of the amount of sodium of the area SA with respect to the amount of sodium of the area SB becomes 1. In one embodiment, the amount of sodium of the area SB may be 0.5 at%, and the barrier layer 500 may be made of at least one of $SiO_x$, $SiN_x$, and $SiO_xN_y$.

Since Y becomes 1, the thickness X of the barrier layer 500 becomes 25.3 nm according to Equation 1, and therefore the barrier layer 500 may have a thickness of 25.3 nm. Here, a process error may occur depending on location of the barrier layer 500 in the substrate 100, and the thickness of the barrier layer 500 may be 20.3 nm to 30.3 nm.

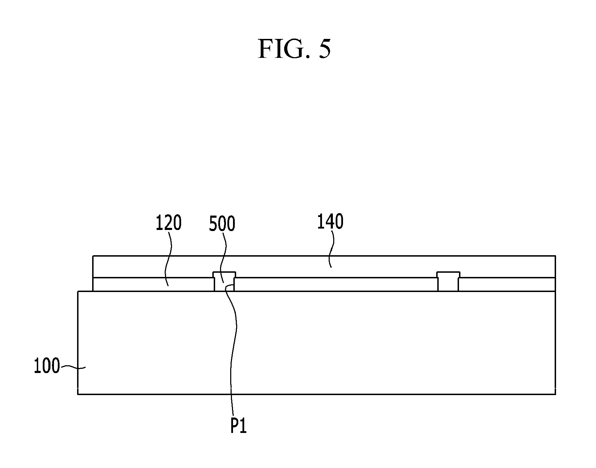

Next, as shown in FIG. 5, a photoactive layer 140 is formed on the first electrode 120 after removing the deposition mask. The photoactive layer 140 may be formed using (utilizing) a selenization process or an evaporation method after a sputtering process.

For example, the sputtering process and the selenization process may sequentially form a first thin film (including a compound of group I and group III elements) and a second thin film (including a group III element). Here, the first thin film and the second thin film are precursor thin films for forming the photoactive layer. In addition, the second thin film may be formed first and then the first thin film may be formed, or the first thin film and the second thin film may be formed alternately in a multiple-layered structure as necessary.

The group I element may be, for example, copper (Cu), silver (Ag), gold (Au) or a combination thereof, and the group III element may be, for example, indium (In), gallium (Ga), or a combination thereof.

The group III element of the first thin film and the group III element of the second thin film may be different from each other. For example, the group III element of the first thin film may be gallium and the group III element of the second thin film may be indium. Here, the group I element may be copper.

Then, a heat treatment is performed under an atmosphere of a gas containing group VI elements (such as selenium (Se) or sulfur (S)) so as to complete the formation of the photoactive layer 140. Here, the heat treatment may be conducted at about 400°C to about 600°C for about 30 minutes to about 120 minutes. When the heat treatment is performed, an upper surface of the first electrode (contacting the photoactive layer 140) may react with Se such that a $MoSe_2$ layer may be formed. The $MoSe_2$ layer forms an ohmic junction between the first electrode and the photoactive layer to thereby reduce a contact resistance.

Alternatively, the evaporation method may form the photoactive layer on the substrate using (utilizing) a plurality of evaporation sources.

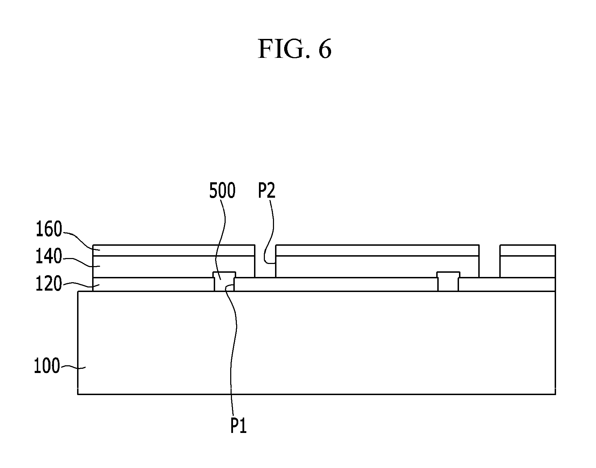

As shown in FIG. 6, a buffer layer 160 is formed on the photoactive layer 140. Then, a through-groove P2 is formed in the buffer layer 160 and the photoactive layer 140 using (utilizing) scribing.

As shown in FIG. 2, a second electrode 180 is formed on the buffer layer 160, and then the second separation groove P3 is formed using (utilizing) scribing so that the substrate 100 is separated into the respective cells.

The second electrode 180 may be made of ZnO by depositing a ZnO target with a direct current (DC) or a radio frequency (RF) sputtering method, or by using (utilizing) a reactive sputtering method using (utilizing) a Zn target, or an organic metal chemical vapor deposition method.

As discusesd above, embodiments of the invention can provide a solar cell comprising: a substrate; a plurality of first electrodes on the substrate, each of the first electrodes being separated by first separation grooves; a plurality of barrier layers, wherein each barrier layer is formed in a said first separation groove; a plurality of photoactive layers, wherein each photoactive layer is formed on a said first electrode and a said barrier layer, each photoactive layer including a through-groove exposing a neighboring first electrode of the first electrodes; and a plurality of second electrodes, wherein each second electrode is formed on a said photoactive layer and is arranged to electrically connect with a neighboring first electrode through a said through-groove, wherein a thickness X of each barrier layer is according to Equation 1:

$$\text{Equation 1}$$

$$Y = (-0.388) * \ln(X) + 2.25$$

where Y is a ratio of an amount of sodium in a region of a said photoactive layer overlapping with the barrier layer with respect to an amount of sodium in a region of the photoactive layer overlapping with areas other than the barrier layer.

Embodiments of the invention can also provide a method for manufacturing a solar cell, the method comprising: forming a plurality of first electrodes on a substrate, each of the first electrodes being separated by first separation grooves; forming a plurality of barrier layers comprising an insulating material, wherein each barrier layer is formed in a said first separation groove; forming a plurality of photoactive layers, wherein each photoactive layers is formed on a said first electrode and a said barrier layer, each photoactive layer including a through-groove configured to expose a neighboring first electrode of the first electrodes; and forming a plurality of second electrodes, wherein each second electrode is electrically connected with a neighboring first electrode through a said through-groove, wherein a thickness X of each barrier layer is calculated according to Equation 1:

$$\text{Equation 1}$$

$$Y = (-0.388)*\ln(X) + 2.25$$

where Y is a ratio of an amount of sodium in a region of a said photoactive layer overlapping with the barrier layer with respect to an amount of sodium in a region of the photoactive layer overlapping with areas other than the barrier layer.

While this disclosure has been described in connection with what is presently considered to be practical example embodiments, it is to be understood that the invention is not limited to the disclosed embodiments, but, on the contrary, is intended to cover various modifications and equivalent arrangements included within the scope of the appended claims, and equivalents thereof.

**Claims**

1. A solar cell comprising:

   a substrate;
   a plurality of first electrodes on the substrate, each of the first electrodes being separated by first separation grooves;
   a plurality of barrier layers, wherein each barrier layer is formed in a said first separation groove;
   a plurality of photoactive layers, wherein each photoactive layer is formed on a said first electrode and a said barrier layer, each photoactive layer including a through-groove exposing a neighboring first electrode of the first electrodes; and
   a plurality of second electrodes, wherein each second electrode is formed on a said photoactive layer and is arranged to electrically connect with a neighboring first electrode through a said through-groove,
   wherein a thickness X of each barrier layer is according to Equation 1:

$$\text{Equation 1}$$

$$Y = (-0.388)*\ln(X) + 2.25$$

   where Y is a ratio of an amount of sodium in a region of a said photoactive layer overlapping with the barrier layer with respect to an amount of sodium in a region of the photoactive layer overlapping with areas other than the barrier layer.

2. The solar cell of claim 1, wherein each barrier layer comprises an insulating material.

3. The solar cell of claim 2, wherein the insulating material comprises at least one of $SiO_x$, $SiN_x$, and $SiO_xN_y$.

4. The solar cell of any one of claims 1 to 3, wherein each first electrode comprises molybdenum, and each second electrode comprises IZO, ITO, and/or AZO.

5. The solar cell of any one of claims 1 to 4, wherein each photoactive layer comprises a CIGS-based material.

6. The solar cell of any one of claims 1 to 5, wherein each second electrode comprises a second separation groove exposing a neighboring first electrode of the first electrodes, and
   each through-groove is between a corresponding one of the first separation grooves separating the corresponding first electrode from the neighboring first electrode and a said second separation groove.

7. The solar cell of any one of claims 1 to 6, wherein the thickness X of each barrier layer is from 20.3 nm to 30.3 nm.

8. A method for manufacturing a solar cell, the method comprising:

forming a plurality of first electrodes on a substrate, each of the first electrodes being separated by first separation grooves;

forming a plurality of barrier layers comprising an insulating material, wherein each barrier layer is formed in a said first separation groove;

forming a plurality of photoactive layers, wherein each photoactive layers is formed on a said first electrode and a said barrier layer, each photoactive layer including a through-groove configured to expose a neighboring first electrode of the first electrodes; and

forming a plurality of second electrodes, wherein each second electrode is electrically connected with a neighboring first electrode through a said through-groove,

wherein a thickness X of each barrier layer is calculated according to Equation 1:

$$\text{Equation 1}$$

$$Y = (-0.388)*\ln(X) + 2.25$$

where Y is a ratio of an amount of sodium in a region of a said photoactive layer overlapping with the barrier layer with respect to an amount of sodium in a region of the photoactive layer overlapping with areas other than the barrier layer.

9. The method for manufacturing the solar cell of claim 8, wherein the forming the barrier layer comprises:

disposing a deposition mask configured to expose the first separation grooves on the first electrodes;
depositing the insulating material to each of the first separation grooves utilizing a chemical vapor deposition or a sputtering method; and
removing the deposition mask.

10. The method for manufacturing the solar cell of claim 8, wherein the barrier layer comprises at least one of $SiN_x$, $SiO_x$, and $SiO_xN_y$.

# FIG. 1

FIG. 2

# FIG. 3

FIG. 4

# FIG. 5

FIG. 6

**EUROPEAN SEARCH REPORT**

Application Number

EP 14 19 3933

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | KR 2010 0109312 A (LG INNOTEK CO LTD [KR]) 8 October 2010 (2010-10-08) * abstract; figures 1-7 * * paragraphs [0014] - [0078] * ----- | 1-10 | INV. H01L31/046 H01L31/0392 |
| Y | US 2010/258191 A1 (MIASOLE [US]; MACKIE NEIL M [US]) 14 October 2010 (2010-10-14) * abstract; paragraphs [0016] - [0025], [0056] * ----- | 1-10 | |
| Y | WO 2013/077431 A1 (SHOWA SHELL SEKIYU [JP]) 30 May 2013 (2013-05-30) * abstract * & EP 2 784 827 A1 (SHOWA SHELL SEKIYU [JP]) 1 October 2014 (2014-10-01) * abstract * * paragraphs [0019] - [0020], [0028], [0030], [0039] * ----- | 1-10 | |
| Y | WO 2012/138117 A2 (LG INNOTEK CO LTD [KR]; LEE JIN WOO [KR]) 11 October 2012 (2012-10-11) * abstract * & US 2014/026957 A1 (LEE JIN WOO [KR]) 30 January 2014 (2014-01-30) * abstract; figures 1-7 * * paragraphs [0003], [0014] - [0024], [0026] - [0029], [0038] - [0039], [0042] - paragraphs [0049], [0054] - [0055], [0057] - [0059], [0061], [0066] - [0070], [0075], [0079] - [0081] * ----- | 1-10 | TECHNICAL FIELDS SEARCHED (IPC) H01L |

The present search report has been drawn up for all claims

| Place of search | Date of completion of the search | Examiner |
|---|---|---|
| Berlin | 24 March 2015 | Cichos, Anna |

EPO FORM 1503 03.82 (P04C01)

## ANNEX TO THE EUROPEAN SEARCH REPORT
## ON EUROPEAN PATENT APPLICATION NO.

EP 14 19 3933

This annex lists the patent family members relating to the patent documents cited in  the above-mentioned European search report.
The members are as contained in the European Patent Office EDP file on
The European Patent Office is in no way liable for these particulars which are merely given for the purpose of information.

24-03-2015

| Patent document cited in search report | Publication date | Patent family member(s) | Publication date |
|---|---|---|---|
| KR 20100109312 A | 08-10-2010 | NONE | |
| US 2010258191 A1 | 14-10-2010 | EP 2419940 A2 | 22-02-2012 |
| | | JP 2012523709 A | 04-10-2012 |
| | | KR 20120018136 A | 29-02-2012 |
| | | MY 149756 A | 14-10-2013 |
| | | SG 175978 A1 | 29-12-2011 |
| | | US 2010258191 A1 | 14-10-2010 |
| | | US 2012003785 A1 | 05-01-2012 |
| | | WO 2010120631 A2 | 21-10-2010 |
| WO 2013077431 A1 | 30-05-2013 | CN 103946989 A | 23-07-2014 |
| | | EP 2784827 A1 | 01-10-2014 |
| | | JP 5174230 B1 | 03-04-2013 |
| | | JP 2013115128 A | 10-06-2013 |
| | | US 2014332070 A1 | 13-11-2014 |
| | | WO 2013077431 A1 | 30-05-2013 |
| WO 2012138117 A2 | 11-10-2012 | CN 103597606 A | 19-02-2014 |
| | | EP 2695201 A2 | 12-02-2014 |
| | | KR 20120113125 A | 12-10-2012 |
| | | US 2014026957 A1 | 30-01-2014 |
| | | WO 2012138117 A2 | 11-10-2012 |

EPO FORM P0459

For more details about this annex : see Official Journal of the European Patent Office, No. 12/82